(19) Europäisches Patentamt
European Patent Office
Office européen des brevets

(11) **EP 3 907 884 A1**

(12) **EUROPEAN PATENT APPLICATION**
published in accordance with Art. 153(4) EPC

(43) Date of publication:
**10.11.2021 Bulletin 2021/45**

(51) Int Cl.:
***H03H 9/02*** *(2006.01)*

(21) Application number: **19907323.0**

(22) Date of filing: **27.11.2019**

(86) International application number:
**PCT/CN2019/121109**

(87) International publication number:
**WO 2020/140654 (09.07.2020 Gazette 2020/28)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.12.2018 CN 201811651302**

(71) Applicants:
• **Tianjin University**
**Tianjin 300072 (CN)**

• **Rofs Microsystem (Tianjin) Co., Ltd**
**Tianjin 300462 (CN)**

(72) Inventors:
• **YANG, Qingrui**
**Tianjin 300072 (CN)**
• **PANG, Wei**
**Tianjin 300072 (CN)**
• **ZHANG, Menglun**
**Tianjin 300072 (CN)**

(74) Representative: **Bandpay & Greuter**
**30, rue Notre-Dame des Victoires**
**75002 Paris (FR)**

(54) **APPARATUS AND METHOD FOR ADJUSTING PERFORMANCE OF ACOUSTIC RESONATOR ON THE BASIS OF BEAM AND EAVE DIMENSION**

(57)    The present disclosure relates to a bulk acoustic resonator, including: a substrate; an acoustic mirror; a bottom electrode arranged above the substrate; a top electrode; and a piezoelectric layer arranged above the bottom electrode and between the bottom electrode and the top electrode, wherein: the overlapping region of the acoustic mirror, the bottom electrode, the piezoelectric layer and the top electrode in the thickness direction of the resonator constitutes an effective region of the resonator; an eave structure is formed on the edge of one side of the top electrode, and the projection of the eave structure along the thickness direction of the resonator falls into the region of the acoustic mirror; a beam structure is arranged at the connection portion of the top electrode, the beam structure includes a first beam portion and a second beam portion, the projection of the first beam portion in the thickness direction of the resonator falls into the region of the acoustic mirror, the gap formed by the first beam portion has a first beam gap width, the projection of the second beam portion in the thickness direction of the resonator is beyond the region of the acoustic mirror and overlaps the bottom electrode, and the second beam portion has a second beam gap width; and the effective electromechanical coupling coefficient of the resonator is in the range of 95%-102% of the effective electromechanical coupling coefficient of a reference resonator.

Fig. 4

## Description

## Technical Field

Embodiments of the present disclosure relate to the field of semiconductors, in particular to a bulk acoustic resonator, a filter having the resonator, a method for controlling the performance, particularly an effective electromechanical coupling coefficient, of the bulk acoustic resonator, and electronic equipment having the filter or the resonator.

## Background Art

A bulk acoustic filter has the advantages of low insertion loss, high rectangular coefficient, high power capacity and the like. Therefore, it is widely used in contemporary wireless communication systems and is an important component that determines the quality of radio frequency signals to enter and exit the communication systems.

The quality of the filter is closely related to various performance indicators of a resonator. A bulk acoustic resonator generally has two resonance frequencies, the frequency point with the minimal impedance is defined as series resonance frequency $f_s$ and the corresponding impedance is series impedance Rs, the frequency point with the maximal impedance is defined as parallel resonance frequency $f_p$ and the corresponding impedance is parallel impedance $R_p$, and an effective electromechanical coupling coefficient is approximately defined as $K_{t,eff}^2 = \frac{f_p - f_s}{f_s}$ to measure the piezoelectric conversion efficiency in the resonator. Generally, the series resonance frequency of the resonator determines the center frequency of the filter, the effective electromechanical coupling coefficient of the resonator determines the bandwidth and the roll-off characteristics of the filter, and the series impedance and the parallel impedance of the resonator determine the passband insertion loss and the return loss. Generally speaking, the higher the $R_p$ of the resonator is, the lower the $R_s$ is, and the better the passband insertion loss of the corresponding filter is. For a specific filter design, it is usually desirable to improve the $R_p$ of the resonator while ensuring that the effective electromechanical coupling coefficient of the resonator is basically unchanged. However, most of the current structures for improving the $R_p$ of the resonator will lead to a decrease in the effective electromechanical coupling coefficient. Therefore, how to design the structure dimension of the resonator to achieve an overall performance improvement is an important problem in filter design.

In addition, the performance of the bulk acoustic filter is determined by the bulk acoustic resonator forming it. For example, the resonance frequency of the bulk acoustic resonator determines the working frequency of the filter, the effective electromechanical coupling coefficient $(K_{t,eff}^2)$ determines the bandwidth and the roll-off of the filter, and the quality factor determines the insertion loss of the filter. In an era when frequency band resources are becoming more and more scarce, a high-quality filter usually requires that the resonator has multiple types of $K_{t,eff}^2$, the $K_{t,eff}^2$ of the resonator is determined by the stacking thickness of the resonator. Usually, all resonators in the entire silicon chip have the same $K_{t,eff}^2$, so how to realize the fine tuning of the $K_{t,eff}^2$ of the resonators within a certain small range is an important problem that needs to be solved urgently in the design of high-performance filters.

## Summary of the Invention

In order to solve at least one aspect of the above-mentioned technical problems in the prior art or provide a way to solve at least one aspect of the above-mentioned technical problems, the present disclosure is proposed.

According to one aspect of the embodiments of the present disclosure, a bulk acoustic resonator is proposed, including: a substrate; an acoustic mirror; a bottom electrode arranged above the substrate; a top electrode; and a piezoelectric layer arranged above the bottom electrode and between the bottom electrode and the top electrode, wherein: the overlapping region of the acoustic mirror, the bottom electrode, the piezoelectric layer and the top electrode in the thickness direction of the resonator constitutes an effective region of the resonator; and a beam structure is arranged at the connection portion of the top electrode, the beam structure includes a first beam portion, the projection of the first beam portion in the thickness direction of the resonator falls into the region of the acoustic mirror, and the gap formed by the first beam portion has a beam gap height and a first beam gap width.

Optionally, the first beam gap width ranges from 0.75 $\mu$m to 3.5 $\mu$m. Furthermore, the first beam gap width ranges from 0.75 $\mu$m to 2 $\mu$m, and further optionally, the first beam gap width is about 1 $\mu$m.

Optionally, the beam gap height is in the range of 100Å-4000Å.

Optionally, the beam structure further includes a second beam portion, the projection of the second beam portion in the thickness direction of the resonator is beyond the region of the acoustic mirror and overlaps the bottom electrode, and the second beam portion has the beam gap height and a second beam gap width. Further optionally, the second beam gap width is in the range of 2 $\mu$m to 8 $\mu$m.

Optionally, the resonator further includes an eave structure formed on the edge of one side of the top electrode, the projection of the eave structure along the thickness direction of the resonator falls into the region of the acoustic mirror, and the gap formed by the eave structure has an eave gap height and an eave gap width. Optionally, the eave gap width is different from the first beam gap width of the beam structure.

Optionally, the effective electromechanical coupling coefficient of the resonator is in the range of 95%-102% of the effective electromechanical coupling coefficient of a reference resonator. Further, the effective electromechanical coupling coefficient of the resonator is the same as the effective electromechanical coupling coefficient of the reference resonator.

According to another aspect of the embodiments of the present disclosure, a method for controlling the effective electromechanical coupling coefficient of a bulk acoustic resonator is proposed. The resonator includes: a substrate; an acoustic mirror; a bottom electrode arranged above the substrate; a top electrode; and a piezoelectric layer arranged above the bottom electrode and between the bottom electrode and the top electrode, wherein: the overlapping region of the acoustic mirror, the bottom electrode, the piezoelectric layer and the top electrode in the thickness direction of the resonator constitutes an effective region of the resonator; an eave structure is formed on the edge of one side of the top electrode, the projection of the eave structure along the thickness direction of the resonator falls into the region of the acoustic mirror, and the gap formed by the eave structure has an eave gap width; and a beam structure is arranged at the connection portion of the top electrode, the beam structure includes a first beam portion and a second beam portion, the projection of the first beam portion in the thickness direction of the resonator falls into the region of the acoustic mirror, the gap formed by the first beam portion has a first beam gap width, and the projection of the second beam portion in the thickness direction of the resonator is beyond the region of the acoustic mirror and overlaps the bottom electrode. The method includes the step of selecting the eave gap width and the first beam gap width, so that the effective electromechanical coupling coefficient of the resonator is in the range of 95%-102% of the effective electromechanical coupling coefficient of a reference resonator. Optionally, the eave gap width and the first beam gap width are selected, so that the effective electromechanical coupling coefficient of the resonator is the same as the effective electromechanical coupling coefficient of the reference resonator. Optionally, the method includes: selecting the beam gap height and/or the eave gap height.

According to still another aspect of the embodiments of the present disclosure, a filter is proposed, including: a series branch, including a plurality of series resonators; and a plurality of parallel branches, each parallel branch including at least one parallel resonator, wherein: the effective electromechanical coupling coefficient of at least one resonator among the at least one parallel resonator and the plurality of series resonators is different from the effective electromechanical coupling coefficients of the other resonators, and the at least one resonator has the above-mentioned first beam gap width or the eave gap width. Further, at least two resonators have different effective electromechanical coupling coefficients on the basis of the difference between the first beam gap widths or the difference between the eave gap widths. Or, the at least two resonators have different effective electromechanical coupling coefficients on the basis of the difference between the first beam gap width and the eave gap width.

According to yet another aspect of the embodiments of the present disclosure, a filter is proposed, including: a series branch, including a plurality of series resonators; and a plurality of parallel branches, each parallel branch including at least one parallel resonator, wherein: at least one resonator among the at least one parallel resonator and the plurality of series resonators has the above-mentioned beam structure and the above-mentioned eave structure, and the effective electromechanical coupling coefficient of the at least one resonator is in the range of 95%-102% of the effective electromechanical coupling coefficient of a reference resonator. Further, the effective electromechanical coupling coefficient of the at least one resonator is the same as the effective electromechanical coupling coefficient of the reference resonator.

The embodiments of the present disclosure further relate to electronic equipment, including the above-mentioned filter or the above-mentioned resonator.

**Brief Description of the Drawings**

The following description and the drawings can better help understand these and other features and advantages in various embodiments disclosed in the present disclosure. The same reference signs in the figures always denote the same components, wherein:

Fig. 1 is a schematic structural diagram of a bulk acoustic resonator in the prior art;
Fig. 2 is an equivalent electromechanical model diagram of an effective region of the bulk acoustic resonator in Fig. 1;
Fig. 3 is a BVD model of the bulk acoustic resonator in Fig. 1;
Fig. 4 is a schematic structural diagram of a bulk acoustic resonator according to an exemplary embodiment of the present disclosure;
Fig. 5 is a BVD model of the bulk acoustic resonator in Fig. 4;
Fig. 6 is an equivalent electromechanical model diagram of the effective region of the bulk acoustic resonator in Fig. 4;
Fig. 7 is a schematic structural diagram of a bulk acoustic resonator according to an exemplary embodiment of the present disclosure;
Fig. 8 is an equivalent electromechanical model diagram of the effective region of the bulk acoustic resonator in Fig. 7;

Fig. 9 is a BVD model of the bulk acoustic resonator in Fig. 7;

Fig. 10 is a schematic structural diagram of a bulk acoustic resonator according to an exemplary embodiment of the present disclosure;

Fig. 11 is a curve diagram of the dimension of an eave structure and the parallel impedance of the bulk acoustic resonator under different dimensions (beam gap widths) of a beam structure, where the horizontal axis represents the dimension of the eave structure, and the vertical axis represents the parallel impedance value; and

Fig. 12 is a typical dispersion curve diagram of four lamb wave modes S0, S1, A0 and A1 propagating laterally in the bulk acoustic resonator.

**Detailed Description of the Embodiments**

The technical solutions of the present disclosure will be further described below in detail through embodiments and in conjunction with the drawings. In the specification, the same or similar reference signs indicate the same or similar components. The following description of the embodiments of the present disclosure with reference to the drawings is intended to explain the general inventive concept of the present disclosure, and should not be construed as a limitation to the present disclosure.

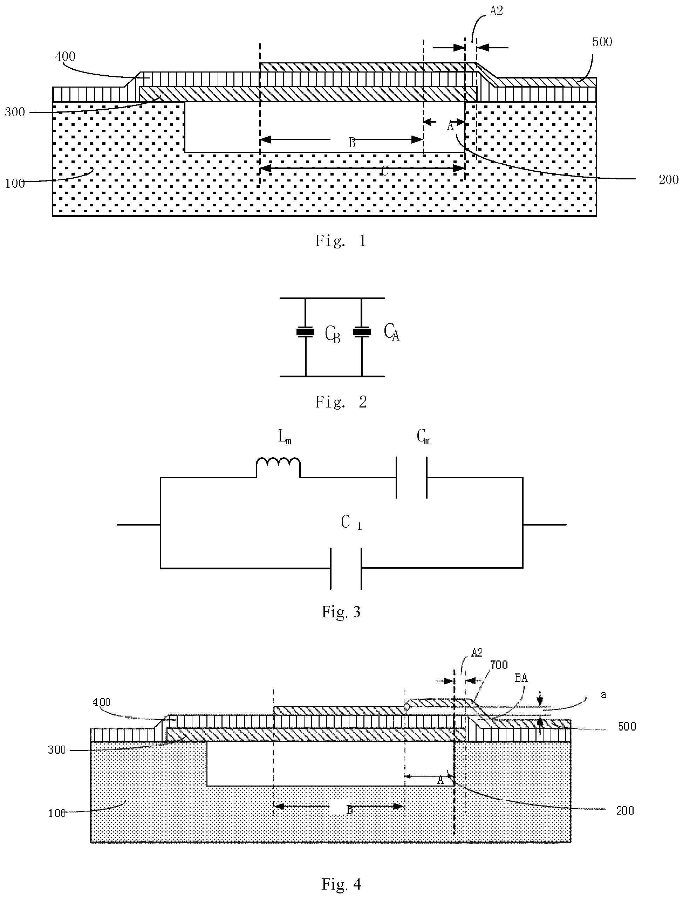

Fig. 1 is a schematic diagram of a basic structure of a resonator in the prior art. The region shown by C in Fig. 1 is an effective region of the resonator, which is composed of a main body region B and a critical region A, and includes a top electrode 500, a piezoelectric layer 400, a bottom electrode 300, an acoustic mirror 200 and a high-resistance silicon substrate 100. When alternating current of specific frequency is applied to the resonator, since the material of the piezoelectric layer 400 has an inverse piezoelectric effect, the electrical energy is converted into mechanical energy, and the mechanical energy is mainly manifested as a piston acoustic wave mode perpendicular to the surface of the piezoelectric layer. The boundary structure of the resonator will significantly affect the performance of the resonator. Specifically, the boundary condition of the effective region on the side of a connection edge of the top electrode is different from the boundary condition of the effective region on the side of a non-connection edge of the top electrode. In Fig. 1, the left side shows the condition of the non-connection edge of the top electrode, and the right side shows the condition of the connection edge of the top electrode. It can be seen that, on the left side of the effective region, acoustic waves are propagated into the substrate 100 and the piezoelectric layer 400 above the substrate through the suspended piezoelectric layer and the bottom electrode; while on the right side of the effective region, the acoustic waves will leak into the high-resistance silicon substrate 100 and the piezoelectric layer 400 through a region A2. In the region A2, since electrodes are arranged on the upper and lower sides of the piezoelectric layer, a high-order tuning bulk acoustic resonator with the same frequency is formed, thereby consuming more acoustic wave energy. The leakage of acoustic wave energy will reduce the parallel impedance $R_P$ of the device and the effective electromechanical coupling coefficient $K^2_{t,eff}$, which will eventually reduce the overall performance of the device.

The effective region C can be considered to be formed by connecting the effective region B and the critical region A in parallel, the equivalent electromechanical model of the effective region C is shown in Fig. 2, and the total capacitance $C_1$ of the effective region C is:

$$C_1 = C_B + C_A \qquad (1)$$

The BVD model of the graph shown in Fig. 1 is as shown in Fig. 3, and the series resonance frequency, the parallel resonance frequency and the effective electromechanical coupling coefficient of the BVD model are respectively:

$$\omega_S = \frac{1}{\sqrt{Lm*Cm}} \qquad (2)$$

$$\omega_P = \sqrt{1 + \frac{C_m}{C_1}} \qquad (3)$$

$$K^2_{t,eff} = \frac{\pi^2}{4} \left( \frac{\omega_P - \omega_S}{\omega_P} \right) \qquad (4)$$

In order to improve the performance on the right side of the effective region of the device, the top electrode 500 can be processed into a beam structure 700 on one side of the connection edge of the top electrode, as shown in Fig. 4. The region shown by B in Fig. 4 is the effective region of the resonator and has first acoustic impedance; and A represents the distance of the beam structure 700 inside the effective region, and the height of the beam structure 700 in the effective region from the piezoelectric layer 400 is a.

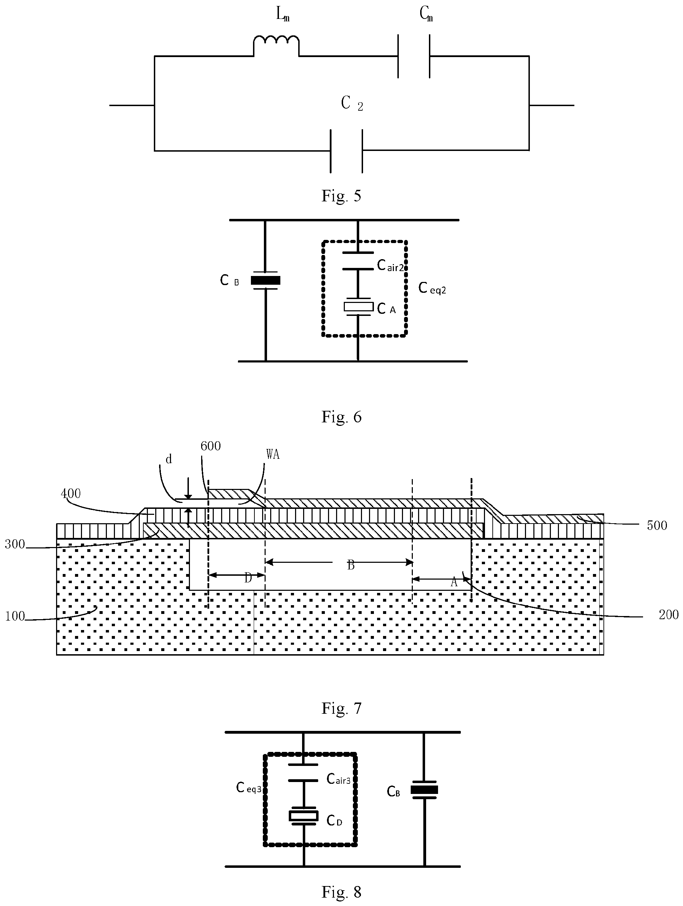

The equivalent electromechanical model of the effective region B and the portion (corresponding to the first beam portion) of the beam structure 700 in the region A is shown in Fig. 6, and $C_B$ represents the capacitance of the region B. $C_{eq2}$ is formed by connecting the capacitance Cair of a cavity BA and the capacitance $C_A$ of the material of the piezoelectric layer 400 in series. The formulas are:

$$C_{air2} = \frac{\varepsilon_0 A}{a} \qquad (5)$$

$$C_{eq2} = \frac{C_{air2} * C_A}{C_{air2} + C_A} = \frac{C_A}{1 + \frac{C_A}{C_{air2}}} \qquad (6)$$

$$C_2 = C_B + C_{eq2} \qquad (7)$$

It can be seen from formula (5) that the air capacitance of the region A is proportional to the length of the region A. It can be seen from formula (6) that $C_{eq2}$ is less than $C_A$; and by comparing formula (1) with formula (7), it can be seen that $C_2$ is less than Ci, that is, the addition of the beam portion reduces the capacitance of the resonator compared with the reference condition.

The BVD model of the graph shown in Fig. 4 is as shown in Fig. 5, and the series resonance frequency, the parallel resonance frequency and the effective electromechanical coupling coefficient of the BVD model are respectively:

$$\omega_S = \frac{1}{\sqrt{Lm * Cm}} \qquad (8)$$

$$\omega_{P,2} = \sqrt{1 + \frac{C_m}{C_2}} \qquad (9)$$

$$K_{t,eff,2}^2 = \frac{\pi^2}{4} \left( \frac{\omega_{P,2} - \omega_S}{\omega_{P,2}} \right) \qquad (10)$$

By comparing formula (2) with formula (8), it can be seen that the addition of the beam portion does not change the series resonance frequency of the resonator. By comparing formula (3) with formula (9), it can be seen that since $C_1$ is greater than $C_2$, $\omega_P$ is less than $\omega_{P,2}$, that is, the addition of the beam portion increases the parallel resonance frequency of the resonator. By comparing formula (4) with formula (10), it can be seen that $K_{t,eff}^2$ is less than $K_{t,eff,2}^2$, that is, the addition of the beam portion increases the effective electromechanical coupling coefficient of the resonator. The introduction of the beam makes the high-order tuning resonator in the region A2 become a smaller equivalent capacitor at the working frequency of the main resonator, which reduces the consumption of the acoustic wave energy, thereby being conducive to improving the overall effective electromechanical coupling coefficient of the resonator.

On the basis of the above description, the present disclosure proposes a bulk acoustic resonator, including:

a substrate 100;
an acoustic mirror 200;
a bottom electrode 300 arranged above the substrate;
a top electrode 500; and
a piezoelectric layer 400 arranged above the bottom electrode and between the bottom electrode and the top electrode,
wherein:

the overlapping region of the acoustic mirror 200, the bottom electrode 300, the piezoelectric layer 400 and the top electrode 500 in the thickness direction of the resonator constitutes an effective region B of the resonator; and
a beam structure 700 is arranged at the connection portion of the top electrode, the beam structure includes a first beam portion, the projection of the first beam portion in the thickness direction of the resonator falls into the region of the acoustic mirror, and the gap formed by the first beam portion has a beam gap height a and a first beam gap width A.

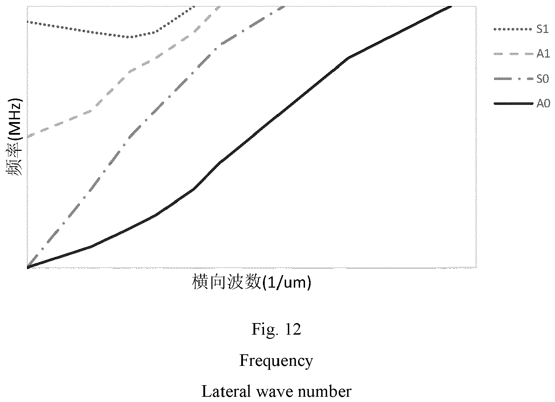

In an optional embodiment, the first beam gap width A ranges from 0.75 $\mu$m to 3.5 $\mu$m. Or, the first beam gap width A is approximately 1/4 of the wavelength of the S1 mode lamb wave in a main resonance region at the parallel frequency of the resonator (see Fig. 12); or the first beam gap width A is between 1/4 of the wavelength of the S1 mode lamb wave in the main resonance region at the parallel frequency of the resonator and 1/4 of the wavelength of the S0 mode lamb wave in the main resonance region at the parallel frequency of the resonator (see Fig. 12).

In a further embodiment, the first beam gap width ranges from 0.75 $\mu$m to 2 $\mu$m. Further, the first beam gap width is about 1 $\mu$m or 2 $\mu$m.

When the bulk acoustic resonator is working, a large number of vibrations are generated in a sandwich structure, if these vibrations are plotted as a dispersion curve according to the relationship between the frequency (f) and the wave number (k) thereof, the curves of a variety modes can be obtained. Fig. 12 is a typical dispersion curve diagram of four lamb wave modes S0, S1, A0 and A1 propagating laterally in the bulk acoustic resonator, and the numerical value of the dispersion curve is determined by the stacking structure of the resonator. The vertical axis represents the vibration frequency, the horizontal axis represents the wave number (k), and the corresponding wavelength is $\lambda = 2\pi/k$. As shown in Fig. 12, the curve of one mode is called an S1 mode, when the vibration frequency is the parallel resonance frequency $f_p$, the corresponding wave number is $k_p$, and the wavelength $\lambda$ of the S1 mode is defined as the following formula:

$$\lambda = \frac{2\pi}{kp}.$$

In an optional embodiment, the beam gap height d is in the range of 100 Å to 4000 Å, for example, can be 100 Å, 300 Å, 500 Å, 2000 Å, 4000 Å, and the like.

As shown in Fig. 4, the beam structure 700 further includes a second beam portion (corresponding to the portion A2 in Fig. 4), the projection of the second beam portion in the thickness direction of the resonator is beyond the region of the acoustic mirror and overlaps the bottom electrode, and the second beam portion has the beam gap height d and a second beam gap width A2. Optionally, the second beam gap width is in the range of 2 μm to 8 μm, for example, can be 2 μm, 4 μm, 6 μm, 8 μm, or the like.

In order to improve the acoustic wave leakage condition on the left side of the effective region, an eave structure 600 can be processed on the left side of the top electrode 110, and the eave structure has a length D and second acoustic impedance, as shown in Fig. 7. The second acoustic impedance of the eave structure 600 does not match the first acoustic impedance of the effective region B, thereby improving the reflection ability and the conversion ability of acoustic waves, as well as the suppression on a parasitic mode, in this way, the performance of the resonator is improved, and the $R_P$ value is further increased. In addition, the eave structure can also adjust the capacitance of the resonator.

The equivalent electromechanical model of the effective region B in Fig. 7 is as shown in Fig. 8, $C_B$ represents the capacitance of the effective region B, and $C_{eq3}$ is formed by connecting the capacitance $C_{air3}$ of a cavity WA and the capacitance $C_D$ of the material of the piezoelectric layer 400 in series. The formulas are:

$$C_{air3} = \frac{\varepsilon_0 D}{d} \qquad (11)$$

$$C_{eq3} = \frac{C_{air3} * C_D}{C_{air3} + C_D} \qquad (12)$$

$$C_3 = C_B + C_A + C_{eq3} \qquad (13)$$

By comparing formula (1) with formula (13), it can be seen that $C_3$ is greater than Ci, that is, the addition of the eave portion increases the capacitance of the resonator compared with the reference condition.

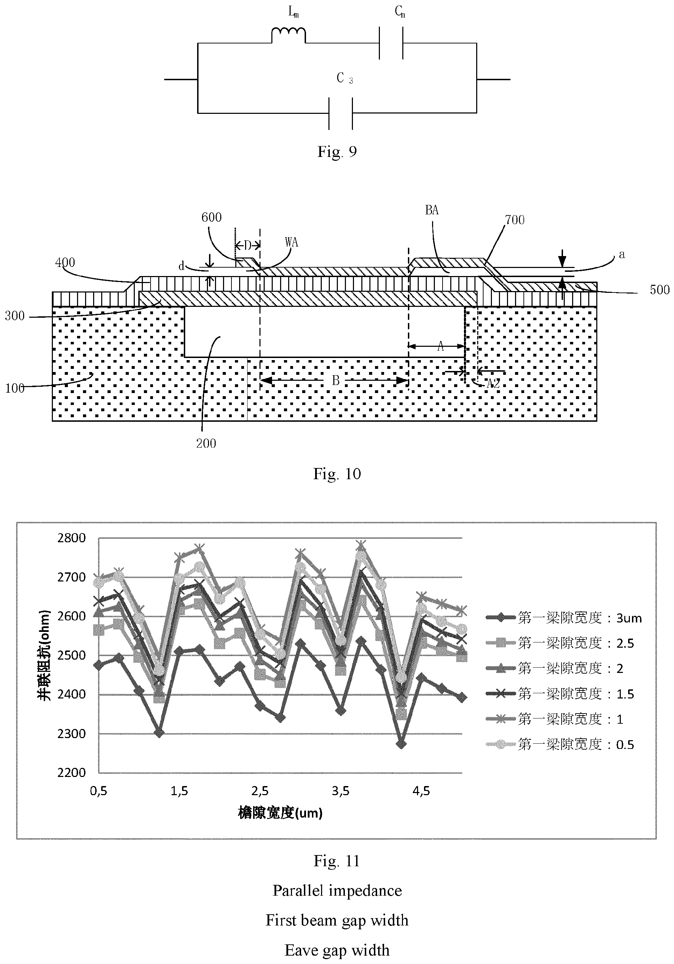

The BVD model of the graph shown in Fig. 7 is as shown in Fig. 9, and the series resonance frequency, the parallel resonance frequency and the effective electromechanical coupling coefficient of the BVD model are respectively:

$$\omega_S = \frac{1}{\sqrt{Lm * Cm}} \qquad (14)$$

$$\omega_{P,3} = \sqrt{1 + \frac{C_m}{C_3}} \qquad (15)$$

$$K_{t,eff,3}^2 = \frac{\pi^2}{4} \left( \frac{\omega_{P,3} - \omega_S}{\omega_{P,3}} \right) \qquad (16)$$

By comparing formula (2) with formula (14), it can be seen that the addition of the eave portion does not change the series resonance frequency of the resonator. By comparing formula (3) with formula (15), it can be seen that since $C_1$ is less than $C_3$, $\omega_P$ is greater than $\omega_{P,3}$, that is, the addition of the eave portion reduces the parallel resonance frequency of the resonator.

By comparing formula (4) with formula (16), it can be seen that $K_{t,eff}^2$ is greater than $K_{t,eff,3}^2$, that is, the addition of the eave portion reduces the effective electromechanical coupling coefficient of the resonator.

It can be seen from the above description that the addition of the beam will increase the effective electromechanical coupling coefficient, and the addition of the eave will reduce the effective electromechanical coupling coefficient. Therefore, when the other parameters of the resonator are constant, the effective electromechanical coupling coefficient of the resonator can be kept basically unchanged by adjusting the width of the region A of the first beam portion and the width of the region D of the eave structure.

As shown in Fig. 7, an eave structure 600 is formed on the edge of one side of the top electrode, the projection of the eave structure 600 along the thickness direction of the resonator falls into the region of the acoustic mirror, and the gap formed by the eave structure has an eave gap height d and an eave gap width D. The eave gap width can be in the range of 0.5 μm to 7 μm, such as 0.5 μm, 4 μm, 5 μm, 7 μm, and so on. The eave gap height can be the same as the beam gap height.

On the other hand, the width A of the first beam portion and the eave gap width D also affect the magnitude of $R_p$. For a specific film thickness combination, by simulating the combination of dimensions of different beam and eave structures, it can be seen from the simulation results (as shown in Fig. 10) that, when the width of the eave changes from 0.5μm to 5μm, with the increase of the width of the beam, changing from 0.5μm to 3μm, the $R_p$ of the resonator will rise first and then drop. When the width of the effective region A of the beam is 1μm, the $R_p$ value of the resonator with the same eave dimension is the maximal. Further, when the dimension of the effective region A of the beam is 1μm, and the eave dimension is 0.75 μm, 1.75 μm, 3 μm and 3.75 μm, an optimal solution with higher global $R_p$ is produced. Accordingly, by optimizing the combination of the beam dimensions and eave dimensions instead of limiting the beam dimensions and eave dimensions to be equal, the performance of the resonator will be further improved, and the effective electromechanical coupling coefficient can be kept basically unchanged. For the combination of films with different thicknesses, the optional width of the beam structure ranges from 0.75 $\mu$m to 3.5 $\mu$m, and further, ranges from 0.75 $\mu$m to 2 $\mu$m, which is about 1/4 of the wavelength of the S1 mode lamb wave in the main resonance region at the parallel frequency $f_p$, or is between 1/4 of the wavelength of the S1 mode lamb wave in the main resonance region at the parallel frequency $f_p$ and 1/4 of the wavelength of the S0 mode lamb wave in the main resonance region at the parallel frequency $f_p$.

Fig. 10 is a schematic structural diagram of a bulk acoustic resonator according to an exemplary embodiment of the present disclosure. As shown in Fig. 10, the resonator includes a substrate 100, an acoustic mirror 200, a bottom electrode 300, a piezoelectric layer 400, a top electrode 500, an eave structure 600 and a beam structure 700. The region shown in B is an effective region of the resonator. In Fig. 10, the beam structure 700 is provided with a first beam portion (corresponding to the region where A in Fig. 10 is located), the beam structure 700 forms a beam gap BA, the eave structure 600 has an eave gap WA, the height of the eave gap is d, and the height of the beam gap is a, the width of the eave gap is D, and the width of the first beam portion of the beam gap is A.

In the present disclosure, the dimension of the eave gap (for example, the eave gap width) and the dimension of the first beam gap (for example, the first beam gap width) can be selected, so that the effective electromechanical coupling coefficient of the resonator provided with the eave structure and the beam structure is in the range of 95%-102% of the effective electromechanical coupling coefficient of a reference resonator (compared with the resonator provided with the eave structure and the beam structure, except for the eave structure and the beam structure, the other structures are completely the same), for example, 95%, 99%, 100%, 102%, and the like. Of course, the dimension of the eave gap (for example, the eave gap width) and the dimension of the first beam gap (for example, the first beam gap width) can also be selected, so that the effective electromechanical coupling coefficient of the resonator provided with the eave structure and the beam structure is different from the effective electromechanical coupling coefficient of the reference resonator (compared with the resonator provided with the eave structure and the beam structure, except for the eave structure and the beam structure, the other structures are completely the same).

In the present disclosure, it is also possible that only the dimension of the first beam gap (for example, the first beam gap width) can be selected, so that the effective electromechanical coupling coefficient of the resonator provided with the beam structure is different from the effective electromechanical coupling coefficient of the reference resonator (compared with the resonator provided with the beam structure, except for the beam structure, the other structures are completely the same).

On the basis of the above description, the present disclosure further proposes a method for controlling the effective electromechanical coupling coefficient of the bulk acoustic resonator, including the step of selecting the eave gap width and the first beam gap width, so that the effective electromechanical coupling coefficient of the resonator is in the range of 95%-102% of the effective electromechanical coupling coefficient of a reference resonator. Optionally, the eave gap width and the first beam gap width are selected, so that the effective electromechanical coupling coefficient of the resonator is the same as the effective electromechanical coupling coefficient of the reference resonator. Optionally, the beam gap height and/or the eave gap height can also be selected to adjust the effective electromechanical coupling coefficient.

Correspondingly, the present disclosure further proposes a filter, including: a series branch, including a plurality of series resonators; and a plurality of parallel branches, each parallel branch including at least one parallel resonator, wherein: the effective electromechanical coupling coefficient of at least one resonator among the at least one parallel resonator and the plurality of series resonators is different from the effective electromechanical coupling coefficients of the other resonators, and the at least one resonator is provided with the above-mentioned beam structure.

Optionally, at least two resonators among the at least one parallel resonator and the plurality of series resonators are provided with the above-mentioned beam structures and the above-mentioned eave structures, and the at least two resonators have different effective electromechanical coupling coefficients on the basis of the difference between the first beam gap width and the eave gap width.

Or, optionally, at least two resonators among the at least one parallel resonator and the plurality of series resonators are provided with the above-mentioned beam structures and the above-mentioned eave structures, and the at least two resonators have different effective electromechanical coupling coefficients on the basis of the difference between the first beam gap widths or the difference between the eave gap widths.

The present disclosure further proposes a filter, including: a series branch, including a plurality of series resonators; and a plurality of parallel branches, each parallel branch including at least one parallel resonator, wherein: at least one resonator among the at least one parallel resonator and the plurality of series resonators includes the above-mentioned beam structure and the above-mentioned eave structure, and the effective electromechanical coupling coefficient of the at least one resonator is in the range of 95%-102% of the effective electromechanical coupling coefficient of a reference resonator. Optionally, the effective electromechanical coupling coefficient of the at least one resonator is the same as the effective electromechanical coupling coefficient of the reference resonator.

The materials of the components of the bulk acoustic resonator according to the present disclosure will be exemplarily and simply illustrated below.

In the present disclosure, the material of the electrodes can be formed by gold (Au), tungsten (W), molybdenum (Mo), platinum (Pt), ruthenium (Ru), iridium (Ir), titanium tungsten (TiW), aluminum (Al), titanium (Ti), osmium (Os), magnesium (Mg), germanium (Ge), copper (Cu), aluminum (Al), chromium (Cr), arsenic doped gold and other similar metals.

In the present disclosure, the material of the piezoelectric layer can be aluminum nitride (A1N), doped aluminum nitride (doped ALN), zinc oxide (ZnO), lead zirconate titanate (PZT), lithium niobate ($LiNbO_3$), quartz (Quartz), potassium niobate ($KNbO_3$) or lithium tantalate ($LiTaO_3$) and other materials, wherein the doped ALN contains at least one rare earth element, such as scandium (Sc), yttrium (Y), magnesium (Mg), titanium (Ti), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.

In the present disclosure, the material of the substrate includes, but is not limited to: single crystal silicon (Si), gallium arsenide (GaAs), sapphire, quartz, etc.

The embodiments of the present disclosure further relate to electronic equipment, including the above-mentioned filter or resonator. It should be pointed out that the electronic equipment here includes, but is not limited to, intermediate products such as radio frequency front ends, filter amplifier modules, and terminal products such as mobile phones, WIFI, and drones.

Although the embodiments of the present disclosure have been shown and described, for those of ordinary skill in the art, it can understood that modifications can be made to these embodiments without departing from the principle and spirit of the present disclosure, and the scope of the present disclosure is defined by the appended claims and their equivalents.

**Claims**

1. A bulk acoustic resonator, comprising:

   a substrate;
   an acoustic mirror;
   a bottom electrode arranged above the substrate;
   a top electrode; and
   a piezoelectric layer arranged above the bottom electrode and between the bottom electrode and the top electrode,
   wherein:

      the overlapping region of the acoustic mirror, the bottom electrode, the piezoelectric layer and the top electrode in the thickness direction of the resonator constitutes an effective region of the resonator; and
      a beam structure is arranged at the connection portion of the top electrode, the beam structure comprises a first beam portion, the projection of the first beam portion in the thickness direction of the resonator falls into the region of the acoustic mirror, and the gap formed by the first beam portion has a beam gap height and a first beam gap width.

2. The resonator according to claim 1, wherein:
   the first beam gap width ranges from 0.75 $\mu$m to 3.5 $\mu$m.

3. The resonator according to claim 2, wherein:
   the first beam gap width ranges from 0.75 $\mu$m to 2 $\mu$m.

4. The resonator according to claim 3, wherein:
   the first beam gap width is about 1 $\mu$m or 2 $\mu$m.

5. The resonator according to any one of claims 2-4, wherein:
   the beam gap height is in the range of $100\overset{\circ}{A}$-$4000\overset{\circ}{A}$.

6. The resonator according to claim 1, wherein:
   the beam structure further comprises a second beam portion, the projection of the second beam portion in the thickness direction of the resonator is beyond the region of the acoustic mirror and overlaps the bottom electrode, and the second beam portion has the beam gap height and a second beam gap width.

7. The resonator according to claim 6, wherein:
   the second beam gap width is in the range of 2 $\mu$m to 8 $\mu$m.

8. The resonator according to any one of claims 1-7, further comprising:
   an eave structure formed on the edge of one side of the top electrode, wherein the projection of the eave structure along the thickness direction of the resonator falls into the region of the acoustic mirror, and the gap formed by the eave structure has an eave gap height and an eave gap width.

9. The resonator according to claim 8, wherein:
   the eave gap width is in the range of 0.5 $\mu$m to 7 $\mu$m .

10. The resonator according to claim 9, wherein:
    the eave gap height is in the range of $100\overset{\circ}{A}$-$4000\overset{\circ}{A}$.

11. The resonator according to any one of claims 8-10, wherein:
    the eave gap width is different from the first beam gap width of the beam structure.

**12.** The resonator according to any one of claims 8-11, wherein:
the effective electromechanical coupling coefficient of the resonator is in the range of 95%-102% of the effective electromechanical coupling coefficient of a reference resonator.

**13.** The resonator according to claim 12, wherein:
the effective electromechanical coupling coefficient of the resonator is the same as the effective electromechanical coupling coefficient of the reference resonator.

**14.** A method for controlling the effective electromechanical coupling coefficient of a bulk acoustic resonator, wherein:

the resonator is the resonator according to any one of claims 8-11; and
the method comprises the step of selecting the eave gap width and the first beam gap width, so that the effective electromechanical coupling coefficient of the resonator is in the range of 95%-102% of the effective electromechanical coupling coefficient of a reference resonator.

**15.** The method according to claim 14, wherein:
the eave gap width and the first beam gap width are selected, so that the effective electromechanical coupling coefficient of the resonator is the same as the effective electromechanical coupling coefficient of the reference resonator.

**16.** The method according to claim 14 or 15, wherein:
the method comprises: selecting the beam gap height and/or the eave gap height.

**17.** A filter, comprising:

a series branch, comprising a plurality of series resonators; and
a plurality of parallel branches, each parallel branch comprising at least one parallel resonator,
wherein:
the effective electromechanical coupling coefficient of at least one resonator among the at least one parallel resonator and the plurality of series resonators is different from the effective electromechanical coupling coefficients of the other resonators, and the at least one resonator is the bulk acoustic resonator according to any one of claims 1-13.

**18.** The filter according to claim 17, wherein:
at least two resonators among the parallel resonator and the plurality of series resonators are the resonators according to any one of claims 8-11, and the at least two resonators have different effective electromechanical coupling coefficients on the basis of the difference between the first beam gap width and the eave gap width.

**19.** The filter according to claim 17, wherein:
at least two resonators among the parallel resonator and the plurality of series resonators are the resonators according to any one of claims 8-11, and the at least two resonators have different effective electromechanical coupling coefficients on the basis of the difference between the first beam gap widths or the difference between the eave gap widths.

**20.** A filter, comprising:

a series branch, comprising a plurality of series resonators; and
a plurality of parallel branches, each parallel branch comprising at least one parallel resonator,
wherein:
at least one resonator among the at least one parallel resonator and the plurality of series resonators is the bulk acoustic resonator according to claim 12.

**21.** The filter according to claim 20, wherein:
the effective electromechanical coupling coefficient of the at least one resonator is the same as the effective electromechanical coupling coefficient of a reference resonator.

**22.** Electronic equipment, comprising the filter according to any one of claims 17-21 or the bulk acoustic resonator according to any one of claims 1-13.

Fig. 1

Fig. 2

Fig. 3

Fig. 4

$L_m$ $C_m$

$C_2$

Fig. 5

$C_B$ $C_{air2}$ $C_A$ $C_{eq2}$

Fig. 6

d 600 WA

400

300

100

500

D B A

200

Fig. 7

$C_{eq3}$ $C_{air3}$ $C_D$ $C_B$

Fig. 8

Fig. 9

Fig. 10

Fig. 11

Parallel impedance

First beam gap width

Eave gap width

Fig. 12

Frequency

Lateral wave number

## INTERNATIONAL SEARCH REPORT

International application No.

**PCT/CN2019/121109**

### A. CLASSIFICATION OF SUBJECT MATTER

H03H 9/02(2006.01)i

According to International Patent Classification (IPC) or to both national classification and IPC

### B. FIELDS SEARCHED

Minimum documentation searched (classification system followed by classification symbols)

H03H

Documentation searched other than minimum documentation to the extent that such documents are included in the fields searched

Electronic data base consulted during the international search (name of data base and, where practicable, search terms used)

EPODOC, WPI, CNKI, CNPAT, IEEE: 桥, 隙, 梁, 檐, 声学谐振, 声波谐振, 体声波谐振, 声波滤波器, 声学滤波器, 体声波滤波器, 电极, bridge, gap, croth, beam, bulk acoustic wave, FBAR, BAW, acoustic wave resonator, acoustic wave filter, acoustic filter, bulk acoustic resonator, acoustic resonator, electrode

### C. DOCUMENTS CONSIDERED TO BE RELEVANT

| Category* | Citation of document, with indication, where appropriate, of the relevant passages | Relevant to claim No. |
|---|---|---|
| X | US 2014176261 A1 (AVAGO TECHNOLOGIES WIRELESS IP SINGAPORE PTE. LTD.) 26 June 2014 (2014-06-26) description, paragraphs [0039]-[0115], and figures 1A-8 | 1-22 |
| X | US 2011084779 A1 (ZHANG, Hao) 14 April 2011 (2011-04-14) description, paragraphs [0054]-[0062], and figures 1A-2B | 1-7, 17, 22 |
| X | CN 103401528 A (AVAGO TECHNOLOGIES GENERAL IP (SIGAPORE) PTE. LTD.) 20 November 2013 (2013-11-20) description, paragraphs [0034]-[0077], and figures 1A-5 | 1-7, 17, 22 |
| PX | CN 110061712 A (TIANJIN UNIVERSITY et al.) 26 July 2019 (2019-07-26) description, paragraphs [0035]-[0052], and figures 1-9 | 1-22 |
| PX | CN 110166014 A (ROFS MICROSYSTEM (TIANJIN) CO., LTD.) 23 August 2019 (2019-08-23) description, paragraphs [0041]-[0097], and figures 1-8B | 1-7, 17, 22 |
| A | US 2014139077 A1 (AVAGO TECHNOLOGIES GENERAL IP SINGAPORE PTE. LTD.) 22 May 2014 (2014-05-22) entire document | 1-22 |

☐ Further documents are listed in the continuation of Box C.  ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 February 2020** | **28 February 2020** |

| Name and mailing address of the ISA/CN | Authorized officer |
|---|---|
| China National Intellectual Property Administration No. 6, Xitucheng Road, Jimenqiao Haidian District, Beijing 100088 China | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2019/121109**

| Patent document cited in search report | | | Publication date (day/month/year) | Patent family member(s) | | | Publication date (day/month/year) |
|---|---|---|---|---|---|---|---|
| US | 2014176261 | A1 | 26 June 2014 | US | 9571064 | B2 | 14 February 2017 |
| | | | | KR | 20150101961 | A | 04 September 2015 |
| US | 2011084779 | A1 | 14 April 2011 | US | 8692631 | B2 | 08 April 2014 |
| CN | 103401528 | A | 20 November 2013 | JP | 2013138425 | A | 11 July 2013 |
| | | | | DE | 102012224460 | B4 | 14 August 2019 |
| | | | | CN | 103401528 | B | 09 June 2017 |
| | | | | DE | 102012224460 | A1 | 27 June 2013 |
| | | | | US | 2012161902 | A1 | 28 June 2012 |
| CN | 110061712 | A | 26 July 2019 | | None | | |
| CN | 110166014 | A | 23 August 2019 | WO | 2019154345 | A1 | 15 August 2019 |
| US | 2014139077 | A1 | 22 May 2014 | US | 9520856 | B2 | 13 December 2016 |
| | | | | US | 2017093368 | A1 | 27 January 2017 |

Form PCT/ISA/210 (patent family annex) (January 2015)